# EUROPEAN PATENT APPLICATION

(11) **EP 4 664 131 A1**
(43) Date of publication of application: **17.12.2025**
(21) Application number: 23920985.1
(22) Date of filing: 06.02.2023
(51) Int. Cl.: G01R 31/392, G01R 31/3835, G01R 31/385, G01R 31/389

(54) **BATTERY DIAGNOSIS DEVICE AND BATTERY DIAGNOSIS METHOD**

(71) Applicant: HITACHI HIGH-TECH CORPORATION, Tokyo 105-6409 (JP)
(72) Inventor: IMAMURA, Akane, Tokyo 100-8280 (JP); KOUNO, Toru, Tokyo 100-8280 (JP); FUJIMOTO, Hiroya, Tokyo 105-6409 (JP); FUJIMOTO, Akira, Tokyo 105-6409 (JP); UEDA, Yutaka, Tokyo 105-6409 (JP)
(74) Representative: Mewburn Ellis LLP
(86) International application number: PCT/JP2023/003696
(87) International publication number: WO 2024/166147

(57) **Abstract**

An object of the invention is to provide a technique capable of determining a state of a battery at high speed and in detail. A battery diagnosis device according to the invention determines whether a battery is in a first state based on a first difference in battery voltage within 4 msec from an end time point at which charging or discharging of the battery is ended, and further determines whether the battery is in a second state based on a second difference in battery voltage thereafter (see FIG. 3).

## Description

### Technical Field

The present invention relates to a technique for diagnosing a state of a battery.

### Background Art

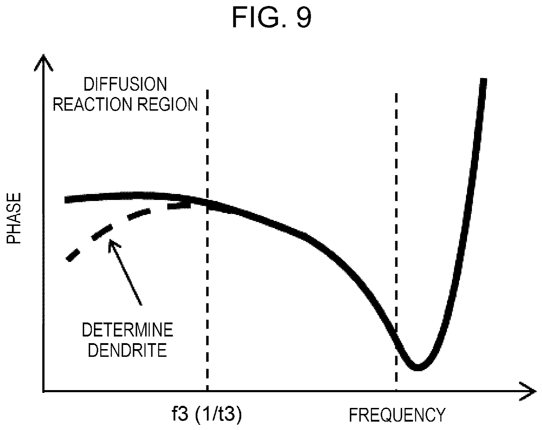

As a method for determining a deterioration state of a storage battery, there is a technique disclosed in PTL 1. With the object of "determining a deterioration state with high accuracy", PTL 1 discloses a technique in which "a voltage between terminals of a secondary battery measured at an end of charging, at a stop of charging, at an end of discharging, or at a stop of discharging is set as a first voltage value, a voltage between the terminals of the secondary battery measured after a predetermined time elapses since the first voltage value is measured is set as a second voltage value, a difference between the first voltage value and the second voltage value is calculated as a change amount ΔV, and the change amount ΔV is compared with a predetermined reference change amount to determine the deterioration state" (see Abstract). PTL 1 further discloses that when an ohmic loss resistance R1 is larger than a reference battery resistance value within 0.01 seconds after the end of charging or discharging, it is determined that the battery is deteriorated (see FIG. 9, 0058 to 0059, 0063, and 0070).

### Citation List

### Patent Literature

PTL 1: JP2011-054413A

### Summary of Invention

### Technical Problem

In PTL 1, presence or absence of the deterioration is determined by calculating a battery resistance R using a voltage change amount after charging and discharging and comparing the battery resistance R with the reference battery resistance value. On the other hand, in an actual storage battery evaluation site, it is necessary to determine whether the battery can be replaced or can be used continuously. Therefore, it is necessary to determine a state of the storage battery in detail. For example, it is conceivable to determine a detailed state such as (a) a failure state or (b) a state in which a state of health (SoH) rapidly decreases. In the related art such as PTL 1, it is determined whether the battery is deteriorated, but it is difficult to determine the detailed state of the battery. Further, it is also required to diagnose the state of the battery at high speed.

The invention has been made in view of the above problems, and an object of the invention is to provide a technique capable of determining a state of a battery at high speed and in detail.

### Solution to Problem

A battery diagnosis device according to the invention determines whether a battery is in a first state based on a first difference in battery voltage within 4 msec from an end time point at which charging or discharging of the battery is ended, and further determines whether the battery is in a second state based on a second difference in battery voltage thereafter.

### Advantageous Effects of Invention

According to the battery diagnosis device of the invention, a state of a battery can be determined at high speed and in detail. Other problems, configurations, advantages, and the like of the invention will become apparent from the following description of embodiments.

### Brief Description of Drawings

[FIG. 1] FIG. 1 is a block diagram of a battery diagnosis device 100 according to Embodiment 1.
[FIG. 2] FIG. 2 shows a screen example of a UI 130.
[FIG. 3] FIG. 3 is a flowchart showing a procedure for a calculation unit 120 to diagnose a battery 200.
[FIG. 4] FIG. 4 is a diagram showing temporal changes in current and voltage output from the battery 200 after discharge.
[FIG. 5] FIG. 5 shows an example of a phase frequency characteristic obtained in S301.
[FIG. 6] FIG. 6 is a Cole-Cole plot created using an amplitude of an amplitude frequency characteristic obtained by performing Fourier transform on a voltage change amount with respect to a time from a first measurement point.
[FIG. 7] FIG. 7 is a diagram showing a temporal change in battery voltage in a pause period after charging.
[FIG. 8] FIG. 8 is a flowchart showing a procedure for diagnosing the battery 200 by the battery diagnosis device 100 according to Embodiment 2.
[FIG. 9] FIG. 9 shows a state in which a phase on the phase frequency characteristic is greatly changed with respect to a reference value in a frequency band equal to or lower than f3.
[FIG. 10] FIG. 10 is a flowchart showing a procedure for diagnosing the battery 200 by the battery diagnosis device 100 according to Embodiment 3.
[FIG. 11] FIG. 11 shows a combination example of a positive electrode material and a negative electrode material.
[FIG. 12] FIG. 12 shows an example of temperature bands.
[FIG. 13] FIG. 13 shows an example of the amplitude frequency characteristic used in S702 and S704.
[FIG. 14] FIG. 14 is a flowchart showing a procedure for determining a temperature band in S705.
[FIG. 15] FIG. 15 shows another configuration example of the battery diagnosis device 100.

### Description of Embodiments

### <Embodiment 1>

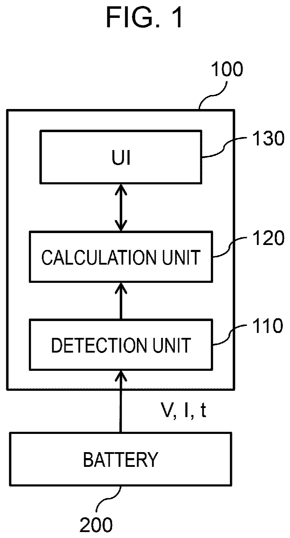

FIG. 1 is a block diagram of a battery diagnosis device 100 according to Embodiment 1 of the invention. The battery diagnosis device 100 includes a detection unit 110, a calculation unit 120, and a user interface (UI) 130. The battery diagnosis device 100 is connected to the battery 200 when diagnosing the battery 200, and can perform charging or discharging on the battery 200, or can instruct a charge and discharge device to start and stop the charging and discharging. The battery 200 may be a storage battery module or a pack including a plurality of batteries.

The detection unit 110 acquires a voltage detection value V, a current detection value I, and a time t which are output from the battery 200. The calculation unit 120 diagnoses a state of the battery 200 using the detection values acquired by the detection unit 110. A diagnosis procedure will be described later. The UI 130 can input a battery type that is information required for diagnosis, instruct a start of diagnosis, output a diagnosis result, and the like.

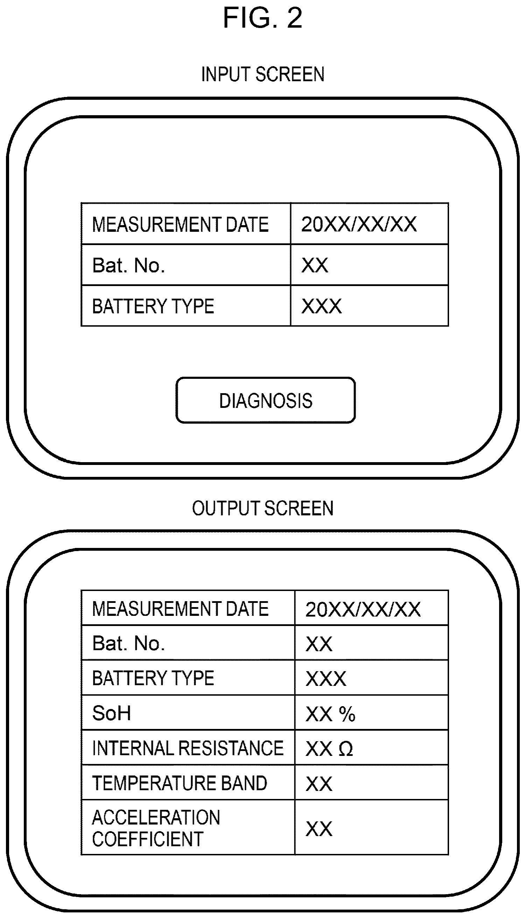

FIG. 2 shows a screen example of the UI 130. An operator can, via the UI 130, input an instruction to the battery diagnosis device 100, check a diagnosis result from the battery diagnosis device 100 at a diagnostic site, and the like.

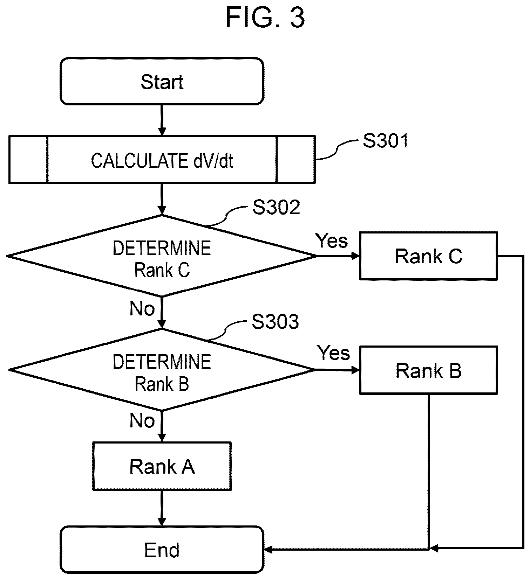

FIG. 3 is a flowchart showing a procedure for the calculation unit 120 to diagnose the battery 200. The calculation unit 120 starts this flowchart at an appropriate timing such as when an instruction is received from the UI 130, when a state of charge (SoC) of the battery 200 reaches a predetermined value, or every predetermined period. The calculation unit 120 determines the state of the battery 200 as one of Rank A, Rank B, and Rank C according to this flowchart. Definitions of these Ranks will be described later.

### (FIG. 3: Step S301)

The calculation unit 120 performs Fourier transform on a battery voltage change after battery current interruption according to the voltage V, the current I, and the time t, which are the input values from the detection unit 110, and obtains a phase frequency characteristic and an amplitude frequency characteristic. Further, dV0/dt0, dV1/dt1, and dV2/dt2 described later are calculated using the result thereof.

### (FIG. 3: Step S302)

When dV0/dt0 (first time change rate of a first difference) is higher than a predetermined reference value, the calculation unit 120 determines that the state of the battery 200 is Rank C (first state). When the state of the battery 200 is not determined to be Rank C, the process proceeds to step S303.

### (FIG. 3: Step S303)

The calculation unit 120 acquires a plurality of measurement results of the voltage V and obtains dV2/dt2 (second time change rate of a second difference) at each measurement result. The calculation unit 120 determines that the state of the battery 200 is Rank B (second state) if either of the following conditions is met: (a) dV2/dt2 fluctuates by the reference value or more between a plurality of measurements; and (b) when the voltage change amount per unit time is measured after charging and discharging, a voltage change amount after charging exceeds a voltage change amount after discharging (in normal products, the voltage change amount after charging is smaller than the voltage change amount after discharging due to the effect of hysteresis). The state of the battery 200 is determined to be Rank A if not determined to be Rank B.

### (Definition of State of Individual Battery)

Rank A, Rank B, and Rank C are defined as follows:
- Rank A: normal usable state;
- Rank B: state in which deterioration is accelerated and a rapid decrease in SoH is observed, or a state immediately before the state; and
- Rank C: state in which an abnormal voltage and an abnormal resistance are shown, and charging and discharging are not possible, or a state immediately before the state.

When a resistance of the battery of Rank C is measured, it can be observed that an internal resistance, a negative electrode resistance, a positive electrode resistance, and a diffusion resistance all have high resistance values. In a steady state after the current interruption, a rapid voltage rise may be observed. In S302, the above is utilized to diagnose whether the state of the battery 200 is Rank C.

When a resistance of the battery of Rank B is measured, an increase in internal resistance, an increase in positive electrode resistance, and a variation in a plurality of measurements can be mainly checked. The positive electrode resistance of the battery of Rank B depends on a charge capacity, and a variation in positive electrode resistance becomes significant when the charge capacity is low. In S303, the above is utilized to diagnose whether the state of the battery 200 is Rank B.

The battery 200 determined to be Rank B or Rank C is recommended to be replaced or reused in consideration of safety. The calculation unit 120 may output a message or the like to that effect on the UI 130. Factors causing these ranks include various factors such as physical damage, contamination with foreign matters, metal Li precipitation, and accumulation of byproducts.

### (Definition of Battery Group)

The calculation unit 120 can further evaluate performance of a battery group and predict an occurrence rate of each Rank by statistically processing measurement results of the occurrence rate of each Rank and SoH for the plurality of batteries.

A relationship between the rank occurrence rate and a cumulative use time of the battery in a Rank C group and a Rank B group can be described as statistical data. This data has, for example, a region where the occurrence rate decreases with time, a region where the occurrence rate is constant regardless of time, and a region where the occurrence rate increases with time. By referring to this curve using the cumulative use time of the battery, it is possible to determine the occurrence rate of each rank and whether the battery can be used continuously. Alternatively, by defining the relationship between the occurrence rate and the cumulative use time in each region using a Weibull distribution or the like, it is possible to determine whether each battery group can be continuously used, predict the occurrence rate of each Rank, and the like. For example, if an m value of the Weibull distribution is equal to or greater than a threshold, it can be determined that the battery group cannot be continuously used. The statistical data created in advance may be stored in the battery diagnosis device 100.

When a SoH is measured for a battery group determined to be the Rank B group, it can be assumed that a relationship between the SoH and the number of batteries having the SoH follows a normal distribution in the same battery group under the same use condition. Quality of the battery group can be quantified from a standard deviation of the distribution and the SoH, and reliability of different battery groups can be compared. For example, when the cumulative use time increases, various individual batteries such as a deteriorated battery and a non-deteriorated battery are generated, and thus distribution variance increases. On the contrary, the variance is small while the cumulative use time is small. Therefore, the quality of the battery group can be quantified using the standard deviation. Alternatively, a process capability index or a numerical value similar thereto can be used as a quality index of the battery group. Other appropriate statistical indices may be used.

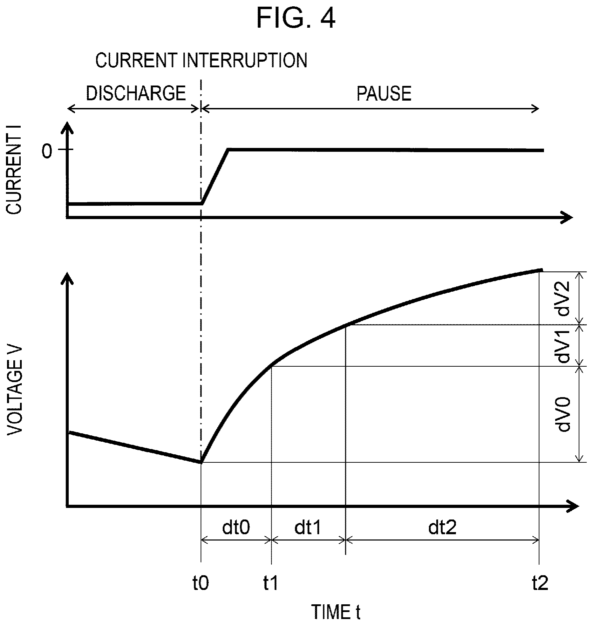

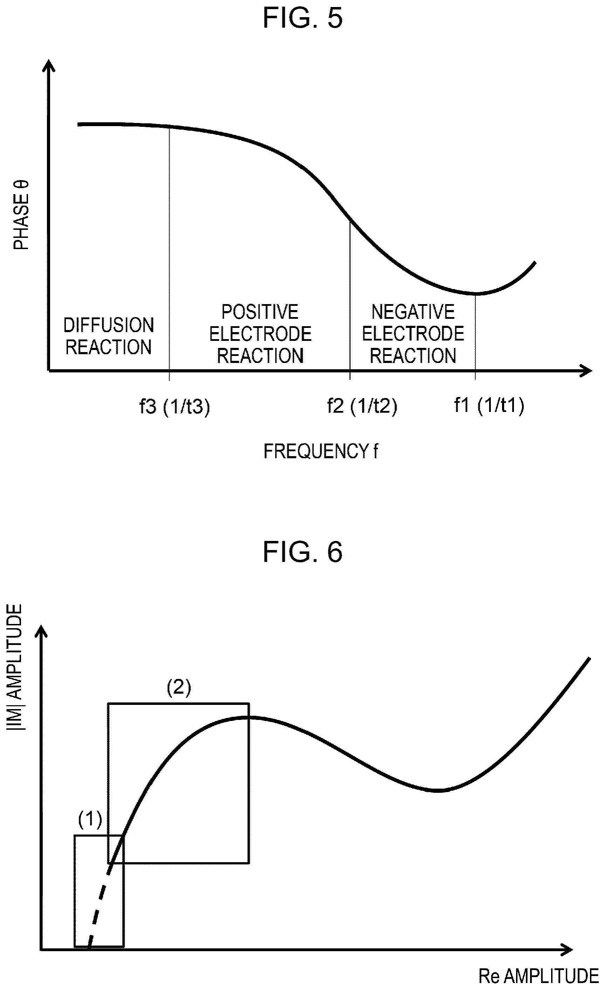

FIG. 4 is a diagram showing temporal changes in current and voltage output from the battery 200 after discharge. The calculation unit 120 performs the Fourier transform on the voltage change amount with respect to a time from the first measurement point after the current interruption to obtain a phase frequency characteristic and an amplitude frequency characteristic. The calculation unit 120 can specify t1, t2, and t3 in FIGS. 4 and 5 using the phase frequency characteristic (FIG. 5) obtained in this manner.

t1 is a start time point at which dV1/dt1 is measured. t2 is an end time point at which dV2/dt2 is measured. t0 is a start time point of the pause period (since a value at a start time point of the pause period may not necessarily be strictly acquired depending on a sampling frequency, for example, a sampling point immediately after t0 may be used). dV0/dt0 can be measured with t0 as the start time point and a time point before t1 as an end time point. An end time point of dV1/dt1 is between t1 and t2. A start time point of dV2/dt2 may be the same as or later than the end time point of dV1/dt1. t3 will be described below. Time regions of dt0 to dt2 may partially overlap one another, or there may be an interval between the regions.

FIG. 5 shows an example of the phase frequency characteristic obtained in S301. In FIG. 5, f1 to f2 is a frequency band in which an influence of a reaction of a negative electrode becomes prominent, f2 to f3 is a frequency band in which an influence of a reaction of a positive electrode becomes prominent, and f3 or lower is a frequency band in which an influence of a diffusion reaction becomes prominent.

For example, t1 can be obtained from a time at which a change amount in phase gradually approaches 0 on a high frequency side in the phase frequency characteristic in FIG. 5. More simply, in the relationship between the voltage change amount and the time shown in FIG. 4, a first inflection point (inflection point that first appears in the pause period) when a time axis is logarithmically represented can also be obtained as t1. A range from f1 to f2 is a section corresponding to a time constant of a negative electrode included in an equivalent circuit of the battery 200 (a section including both sides of a reciprocal of the time constant).

For example, t2 can be obtained from a value corresponding to a time constant of a positive electrode included in the equivalent circuit of the battery 200 in the phase frequency characteristic in FIG. 5. More simply, in the relationship between the voltage change amount and the time shown in FIG. 4, a second inflection point (inflection point that appears second in the pause period) when a time axis is logarithmically expressed can also be obtained as t2. That is, dt2 is within a section divided by two inflection points on a logarithmic time axis.

For example, t3 can be obtained from a frequency at which the change amount in phase with respect to the frequency gradually approaches 0 on a low frequency side in the phase frequency characteristic in FIG. 5.

### (Calculation Procedure of dV0/dt0, dV1/dt1, dV2/dt2)

dV0/dt0 is a voltage change amount per unit time until dt0 elapses from the first measurement point (t0) after the current interruption in FIG. 4. Since the measurement start time (t1) of dV1/dt1 is often set to around 4 msec after the current interruption in this method, a time length of dt0 is set to be within 4 msec. However, since a time zone within 2 msec is particularly a time zone in which an influence of voltage abnormality or resistance abnormality is particularly noticeable, and a sampling period in this method needs to be 1/2 or less of 4 msec, which is the measurement start time (t1) of dV1/dt1, dt0 is preferably within 2 msec. The present inventors have found that dV0/dt0 obtained as described above has a high correlation with an occurrence of the voltage abnormality or the resistance abnormality of the storage battery. Using the above, the determination in step S302 is performed.

FIG. 6 is a Cole-Cole plot created using an amplitude of an amplitude frequency characteristic obtained by performing the Fourier transform on the voltage change amount with respect to the time from the first measurement point. dV1/dt1 corresponds to the voltage change amount per unit time in a range (1) in FIG. 6. This region is a region where the influence of the internal resistance becomes prominent. dV1/dt1 is obtained as the voltage change amount per unit time when dt1 is within 4 msec from t1, for example. However, when setting the range (1), the range (1) is set in an appropriate section in consideration of a sampling period, resolution, and the like of the measurement. The present inventors have found that dV1/dt1 obtained as described above has a high correlation with the internal resistance of the storage battery. Using the above, the determination in step S705 described below is performed.

dV2/dt2 is obtained as a voltage change amount per unit time in any range from t2 to t1. Specifically, dV2/dt2 corresponds to the voltage change amount per unit time in a range (2) in FIG. 6. This region is a region where the influence of the negative electrode becomes prominent. When specifying dt2, dt2 may be appropriately set within the section from t1 to t2 depending on the type, device, use, measurement accuracy, and the like of the battery. The present inventors have found that dV2/dt2 obtained as described above has a high correlation with a deterioration state of the negative electrode of the storage battery. In Embodiment 1, the determination in step S303 is performed using the above.

The Cole-Cole plot cannot necessarily be obtained for all frequencies, and may be partially missing as indicated by a dotted line in FIG. 6. When it is necessary to use the dotted line, the value may be compensated by any interpolation operation.

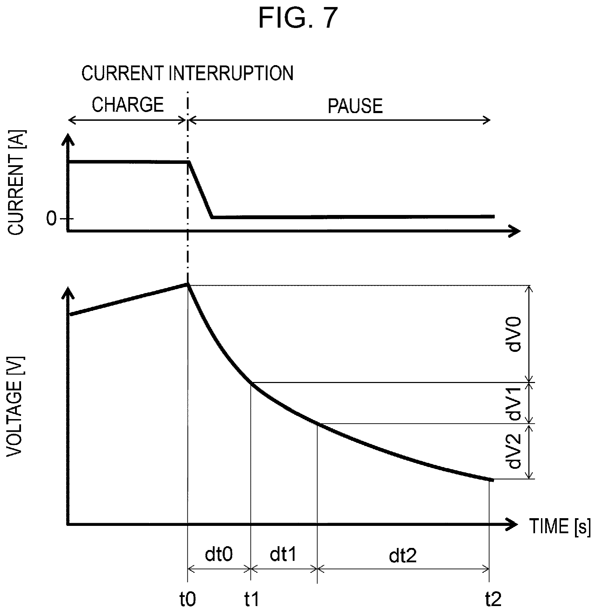

FIG. 7 is a diagram showing a temporal change in battery voltage in the pause period after charging. dV0/dt0, dV1/dt1, and dV2/dt2 can also be obtained from temporal changes in current and voltage output by the battery 200 after charging in the same manner as the method described in FIGS. 4 to 6. The same applies to the following embodiments.

### <Embodiment 1: Summary>

The battery diagnosis device 100 according to Embodiment 1 determines whether the battery 200 is Rank C using dV0/dt0 in the pause period after charging or discharging, and determines whether the battery 200 is Rank B using dV2/dt2. These diagnoses can be performed in an order of, for example, about several tens of milliseconds from the start of the pause period. Therefore, the detailed state of the battery 200 can be diagnosed at high speed.

In the related art, the SoH may be determined from, for example, the internal resistance of the battery. However, in recent years, since storage batteries having a low internal resistance become mainstream, it is difficult to determine the deterioration state and the detailed state of the SoH only by a difference in internal resistance. The diagnosis procedure in the present embodiment is useful in that the detailed state can be diagnosed even for a storage battery having an internal resistance of 1 mΩ or less.

### <Embodiment 2>

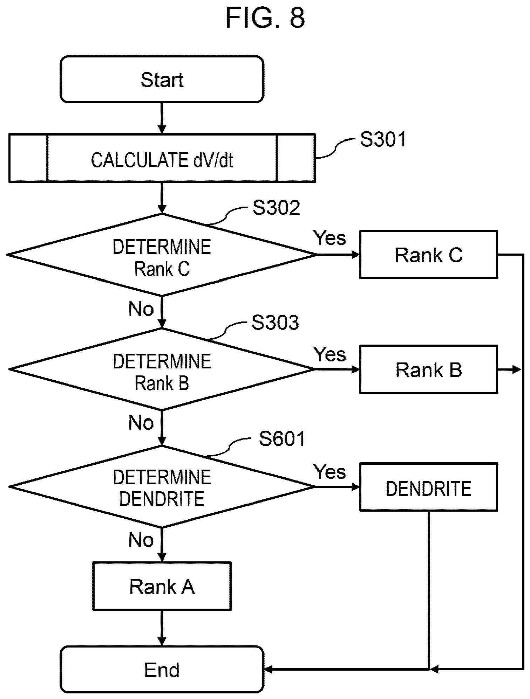

FIG. 8 is a flowchart showing a procedure for diagnosing the battery 200 by the battery diagnosis device 100 according to Embodiment 2 of the invention. In Embodiment 2, if Rank B is not determined in S303, S601 is further performed. Other configurations are the same as those of Embodiment 1.

### (FIG. 8: Step S601)

The calculation unit 120 determines whether a dendrite is generated in the electrode of the battery 200 by using the phase frequency characteristic of the voltage change amount obtained in step S301. For example, in a frequency band equal to or lower than f3 in FIG. 5, when a phase on the phase frequency characteristic decreases by a threshold or more with respect to the reference value, it is determined that the dendrite is generated. When these conditions are not satisfied, Rank A is determined.

### (FIG. 8: Step S601: Supplement)

The present inventors have found that the phase in the frequency band of f3 or lower is influenced by the reaction of the diffusion resistance of the battery 200, and serves as an index of the dendrite generation. In this step, the presence or absence of the dendrite is determined using this fact. Since a battery in which a dendrite is generated may ignite due to a short circuit or the like, it is determined whether the battery can be continuously used in consideration of safety. For example, the calculation unit 120 may determine a risk caused by the dendrite based on a degree of decrease in the phase from the reference value, and present the determination result on the UI 130.

FIG. 9 shows a state in which a phase on the phase frequency characteristic is greatly changed with respect to a reference value in a frequency band equal to or lower than f3. When the phase is lower than the reference value (solid line) by the threshold or more as indicated by the dotted line in FIG. 9, it can be determined that the dendrite is generated. The reference value indicated by the solid line can be acquired, for example, by measuring a normal battery in advance.

### <Embodiment 3>

In Embodiment 3 of the invention, a temperature band is determined for the battery 200 that is not determined as Rank C or Rank B in Embodiment 1. The temperature band is a temperature environment that is most dominant with respect to deterioration of the battery 200, such as a temperature band that is the longest as a past use environment of the battery 200 or a temperature band that accelerates deterioration of the storage battery even instantaneously.

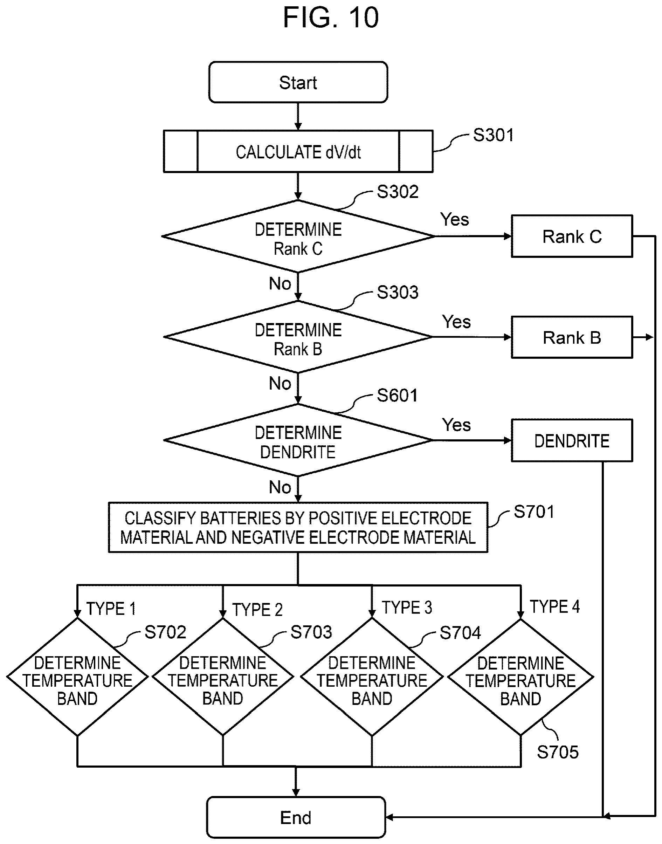

FIG. 10 is a flowchart showing a procedure for diagnosing the battery 200 by the battery diagnosis device 100 according to Embodiment 3 of the invention. In Embodiment 3, if Rank B is not determined in step S303, steps S701 to S705 are further performed. S601 may or may not be performed. Other configurations are the same as those of Embodiments 1 and 2.

### (FIG. 10: Step S701)

The calculation unit 120 classifies the batteries according to the positive electrode material and the negative electrode material of the battery 200. Classification examples will be described later. Here, the battery 200 is classified into any one of types 1 to 4.

### (FIG. 10: Steps S702 to S705)

The calculation unit 120 performs a temperature band determination corresponding to the classification result of S701. S702 is performed for Type 1, S703 is performed for Type 2, S704 is performed for Type 3, and S705 is performed for Type 4. Different temperature band determination processes may be performed for each type of the battery 200, or the same determination process may be performed for any type. Details of the steps will be described later.

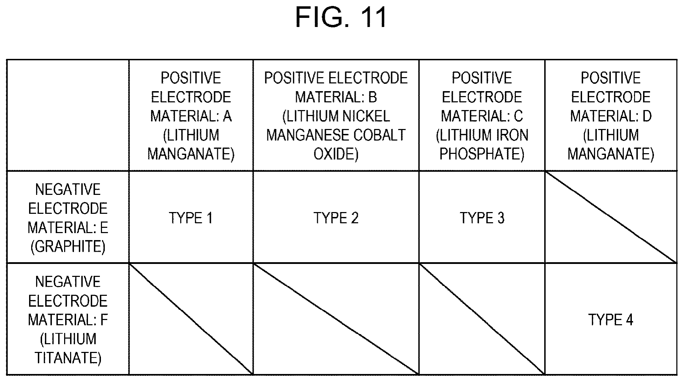

FIG. 11 shows a combination example of a positive electrode material and a negative electrode material. For example, the following combinations are conceivable. Battery type 1: positive electrode material A (lithium manganate) and negative electrode material E (graphite); battery type 2: positive electrode material B (lithium nickel manganese cobalt oxide) and negative electrode material E; battery type 3: positive electrode material C (lithium iron phosphate) and negative electrode material E; and battery type 4: positive electrode material D (lithium manganate) and negative electrode material F (lithium titanate). Batteries other than these four types can also be classified by combinations of various electrode materials.

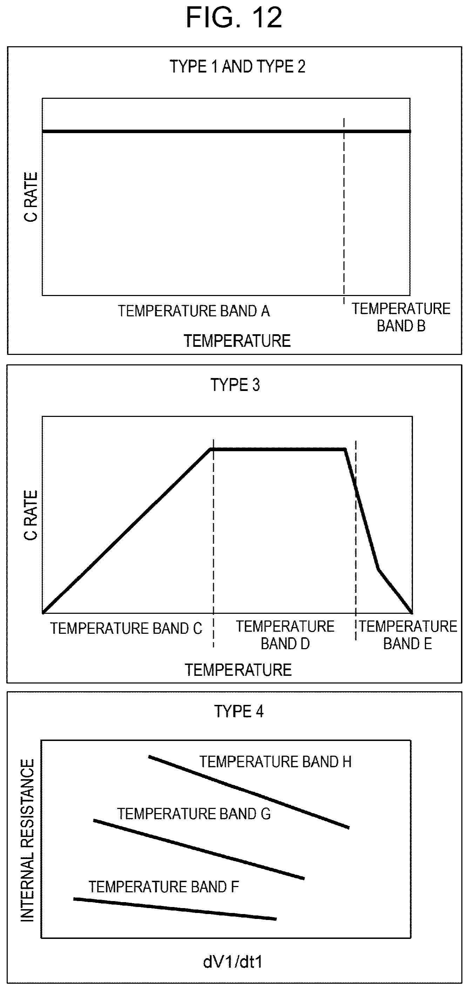

FIG. 12 shows an example of temperature bands. The temperature bands have different definitions depending on the battery type. For Type 1 and Type 2, the temperature bands and a C rate have a relationship as shown in an upper part in FIG. 12. For Type 3, the temperature bands and the C rate have a relationship as shown in a middle part in FIG. 12. For Type 4, the temperature bands, the internal resistance, and dV1/dtl have a relationship as shown in a lower part in FIG. 12. In S702 to S705, the temperature band is determined according to these relationships.

In step S702, when the amplitude on the low frequency side increases with respect to the reference value on the amplitude frequency characteristic calculated in step S301, it is determined that the temperature band of the battery 200 is a temperature band B. If there is no amplitude increase, it is determined that the temperature band of the battery 200 is a temperature band A. An example of the amplitude frequency characteristic in this step will be described later.

In S703, the temperature band of the battery of Type 2 is not determined. This is because the battery of Type 2 tends to deteriorate with the same activation energy regardless of whether the temperature band is the temperature band A or the temperature band B, and thus it is not necessary to distinguish the temperature band when an acceleration coefficient described later is applied. In addition, since a relationship between dV2/dt2 and the SoH can be obtained regardless of the temperature band, the SoH can be estimated using the relationship as described later. Also in this respect, there is no need to distinguish the temperature band for Type 2.

In step S704, when the amplitude on the low frequency side increases with respect to the reference value on the amplitude frequency characteristic calculated in step S301, it is determined that the temperature band of the battery 200 is a temperature band E. If there is no amplitude increase, it is determined that the temperature band of the battery 200 is a temperature band D. An example of the amplitude frequency characteristic in this step is common to the example in S702.

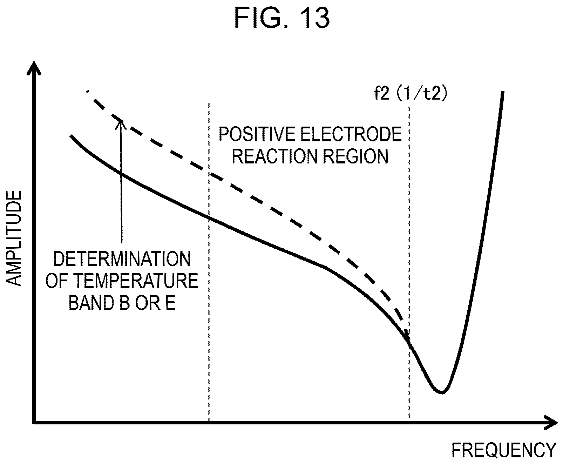

FIG. 13 shows an example of the amplitude frequency characteristic used in S702 and S704. When the battery 200 is deteriorated mainly due to the use of the battery 200 in the temperature band B or E, the influence thereof appears in the reaction between the positive electrode and the diffusion resistance. Therefore, when the amplitude on the low frequency side equal to or lower than f2 increases by a threshold or more with respect to the reference value as indicated by the dotted line in FIG. 13, it can be determined that the battery 200 is used in the temperature band B or E. The reference value (solid line) may be acquired in advance by an actual measurement, for example.

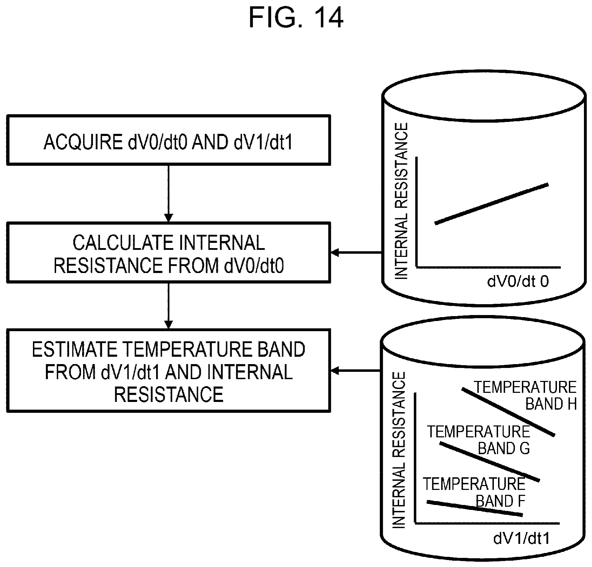

FIG. 14 is a flowchart showing a procedure for determining a temperature band in S705. The calculation unit 120 acquires in advance first data describing a relationship between dV0/dt0 and the internal resistance and second data describing a relationship between dV1/dt1 (third time change rate of the third difference) and the internal resistance in each temperature band (F to H in the example in FIG. 12). For example, the data may be stored in advance in a storage device included in the battery diagnosis device 100.

The calculation unit 120 estimates the internal resistance of the battery 200 by referring to the first data using dV0/dt0. Further, the temperature band of the battery 200 is estimated by referring to the second data using the internal resistance estimated as dV1/dt1. For the second data, a missing portion may be interpolated. For example, when dV1/dt1 corresponding to a region between the temperature bands G and H and the internal resistance are obtained, the temperature band between the temperature bands G and H may be appropriately obtained by interpolation calculation.

In addition to the above, the calculation unit 120 may estimate the C rate used in the past in the battery 200 according to the relationship in FIG. 12. Specifically, the C rate used in the past for the battery can be estimated by referring to the data (temperature band data) describing the relationship in FIG. 12 using the temperature band estimated by the above procedure. For example, when it is estimated that the temperature band of the battery of the type 3 is the temperature band D, it can be estimated that the C rate used in the past for the battery is substantially constant. When it is estimated that the temperature band is the temperature band C or E, it can be at least estimated that the C rate may not be constant.

In addition to the above, the calculation unit 120 may acquire data describing a correlation relationship between dV2/dt2 and the SoH in each temperature band, and estimate the SoH for the battery classified into each temperature band by referring to the data using dV2/dt2. Further, a remaining life of the battery 200 can be predicted by applying an acceleration coefficient corresponding to each temperature band. The acceleration coefficient is set using an eye ring plot created in advance.

### <Embodiment 4>

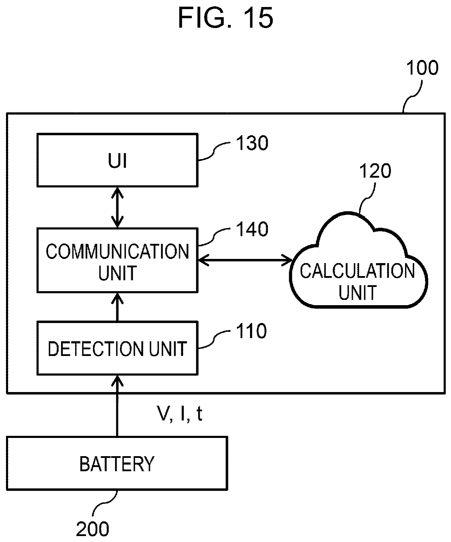

FIG. 15 shows another configuration example of the battery diagnosis device 100. The detection unit 110 may communicate with the calculation unit 120 over a network via a communication unit 140. The calculation unit 120 may learn measurement results of a plurality of batteries and update each determination criterion. Other configurations are the same as those of Embodiments 1 to 3.

### <Modifications of Invention>

The invention is not limited to the above-described embodiments and includes various modifications. For example, the above-described embodiments have been described in detail to facilitate understanding of the invention, and the invention is not necessarily limited to those including all the configurations described above. In addition, a part of a configuration according to a certain embodiment can be replaced with a configuration according to another embodiment, and a configuration according to another embodiment can be added to a configuration according to a certain embodiment. In addition, another configuration can be added to a part of a configuration of each embodiment, and the part of the configuration of each embodiment can be deleted or replaced with another configuration.

In the above embodiments, the detection unit 110 and the calculation unit 120 can be implemented by hardware such as a circuit device where a function thereof is provided, or can also be implemented by a calculation device such as a central processing unit (CPU) executing software where the function is provided.

In the above embodiments, it is desirable that t2 is, for example, within several seconds at the latest from a start time point of the pause period. Since the specific value of t2 varies depending on an individual battery and a battery type, t2 may be appropriately determined according to these.

### Reference Signs List

- 100:: battery diagnosis device
- 110:: detection unit
- 120:: calculation unit
- 130:: UI
- 200:: battery

## Claims

1. A battery diagnosis device that diagnoses a state of a battery, the battery diagnosis device comprising:
a detection unit configured to acquire a detection value of a voltage output by the battery; and
a calculation unit configured to estimate a state of the battery using a difference representing a temporal change of the voltage, wherein
the calculation unit determines whether the battery is in a first state based on, as the difference, a first difference between the voltage at a first calculation start time point after an end time point at which charging or discharging of the battery is ended and the voltage at a first time point at which a first period within 4 msec elapses from the end time point, and
the calculation unit determines whether the battery is in a second state based on, as the difference, a second difference between the voltage at a second calculation start time point after the first calculation start time point and the voltage at a second time point at which a second period elapses from the second calculation start time point.

2. The battery diagnosis device according to claim 1, wherein
the calculation unit determines that the battery is in the first state when a first time change rate of the first difference is equal to or greater than a first threshold,
the calculation unit measures a second time change rate of the second difference a plurality of times, and
the calculation unit determines that the battery is in the second state when a variation between the second time change rates is equal to or greater than a second threshold or when a charging voltage of the battery exceeds a discharging voltage.

3. The battery diagnosis device according to claim 1, wherein
the second period is a section between a frequency of an inflection point at which a slope of a phase changes from minus to plus and a frequency corresponding to a time constant of a negative electrode included in the battery in a phase frequency characteristic obtained by performing Fourier transform on a temporal change of the voltage after the end time point, or
the second period is within a range of a section divided by an inflection point when the temporal change of the voltage after the end time point is represented on a logarithmic time axis.

4. The battery diagnosis device according to claim 1, wherein
when the calculation unit determines that the battery is in the first state, the calculation unit outputs a determination result indicating that the battery is in a state in which an abnormal voltage or an abnormal resistance is indicated and charging and discharging are not possible or a state immediately before the state, and
when the calculation unit determines that the battery is in the second state, the calculation unit outputs a determination result indicating that the battery is in a state in which deterioration of the battery accelerates and a rapid decrease in SoH is observed or a state immediately before the state.

5. The battery diagnosis device according to claim 1, wherein
when determining that the battery is neither in the first state nor in the second state, the calculation unit outputs a determination result indicating that the battery is in a normally usable state, and
when determining that the battery is in the first state or in the second state, the calculation unit outputs a notification indicating that replacement of the battery is recommended even when an integrated use time of the battery does not reach a predetermined usable time.

6. The battery diagnosis device according to claim 1, wherein
the calculation unit defines a relationship between an occurrence rate of each of the first state and the second state and a cumulative use time of the battery by
a region in which the occurrence rate decreases with the cumulative use time,
a region in which the occurrence rate is constant regardless of the cumulative use time, and
a region in which the occurrence rate increases with the cumulative use time, and
the calculation unit determines at least one of whether the battery is continuously usable or the occurrence rate of each of the first state and the second state according to the definition.

7. The battery diagnosis device according to claim 1, wherein
the calculation unit estimates, according to a normal distribution, a relationship between a value of a SoH and the number of batteries having the value of the SoH for a plurality of batteries determined to be in the second state, and
the calculation unit quantifies quality of the battery using a standard deviation of the normal distribution.

8. The battery diagnosis device according to claim 1, wherein
the calculation unit acquires a phase frequency characteristic obtained by performing Fourier transform on a measurement result of a temporal change of the voltage after the end time point, and
the calculation unit determines that a dendrite is generated inside the battery when a phase of a region corresponding to a diffusion resistance included in the battery decreases by a threshold or more with respect to a reference value in the phase frequency characteristic.

9. The battery diagnosis device according to claim 1, wherein
the calculation unit determines whether a type of the battery is a first type, a second type, a third type, or a fourth type according to a material of an electrode included in the battery,
the calculation unit estimates a temperature band that is most dominant for deterioration of the battery for each type of the battery,
when the battery is the first type, the calculation unit estimates the temperature band to be a first temperature band when an amplitude of a region corresponding to a positive electrode included in the battery is increased by a threshold or more with respect to a reference value, and estimates the temperature band to be less than the first temperature band when the amplitude is not increased in an amplitude frequency characteristic obtained by performing Fourier transform on a temporal change of the voltage after the end time point,
when the battery is the second type, the calculation unit does not estimate the temperature band,
when the battery is the third type, the calculation unit estimates the temperature band to be a second temperature band when the amplitude of the region corresponding to the positive electrode included in the battery is increased by a threshold or more with respect to a reference value, and estimates the temperature band to be less than the second temperature band when the amplitude is not increased in an amplitude frequency characteristic obtained by performing the Fourier transform on a temporal change of the voltage after the end time point, and
when the battery is the fourth type, the calculation unit estimates an internal resistance of the battery according to the first difference, and estimates the temperature band using the estimated internal resistance.

10. The battery diagnosis device according to claim 9, wherein
the calculation unit acquires a third time change rate of a third difference of the voltage in a period between the first difference and the second difference,
the calculation unit acquires a correspondence relationship among an internal resistance of the battery, the third time change rate, and the temperature band, and
the calculation unit estimates the temperature band by referring to the correspondence relationship using the estimated internal resistance and the third time change rate.

11. The battery diagnosis device according to claim 9, wherein
the battery of the first type is formed of a first positive electrode material and a first negative electrode material,
the battery of the second type is formed of a second positive electrode material and the first negative electrode material,
the battery of the third type is formed of a third positive electrode material and the first negative electrode material, and
the battery of the fourth type is formed of a fourth positive electrode material and a second negative electrode material.

12. The battery diagnosis device according to claim 9, wherein
the calculation unit acquires temperature band data describing a relationship between the temperature band and a C rate to be used in the temperature band for each of the first type, the second type, and the third type,
the temperature band data describes that the C rate during charging and discharging is constant regardless of the temperature band for the batteries of the first type and the second type,
for the battery of the third type, the temperature band data describes that the C rate during charging and discharging decreases with an increase in temperature in the second temperature band, the C rate during charging and discharging is constant in a third temperature band lower than the second temperature band, and the C rate during charging and discharging decreases with a decrease in temperature in a fourth temperature band lower than the third temperature band, and
the calculation unit estimates a C rate used in the past for the battery by referring to the temperature band data using the estimated temperature band.

13. The battery diagnosis device according to claim 9, wherein
the calculation unit estimates a remaining life of the battery by applying an acceleration constant corresponding to the estimated temperature band.

14. A battery diagnosis method for diagnosing a state of a battery, the battery diagnosis method comprising:
a step of acquiring a detection value of a voltage output by the battery; and
a step of estimating a state of the battery using a difference representing a temporal change of the voltage, wherein
the estimating step determines whether the battery is in a first state based on, as the difference, a first difference between the voltage at a first calculation start time point after an end time point at which charging or discharging of the battery is ended and the voltage at a first time point at which a first period within 4 msec elapses from the end time point, and
the estimating step determines whether the battery is in a second state based on, as the difference, a second difference between the voltage at a second calculation start time point after the first calculation start time point and the voltage at a second time point at which a second period elapses from the second calculation start time point.

15. The battery diagnosis method according to claim 14, wherein
the diagnosis is performed on the battery having an internal resistance of 1 mΩ or less.
